# EUROPEAN PATENT APPLICATION

(11) **EP 0 977 205 A1**
(43) Date of publication of application: **02.02.2000**
(21) Application number: 99305864.3
(22) Date of filing: 23.07.1999
(51) Int. Cl.: G11C 7/00, G11B 23/087, G11B 15/07

(54) **Information processing apparatus and method, and medium that provides a program implementing the method**

(30) Priority: 27.07.1998 JP 21086498
(71) Applicant: SONY CORPORATION, Tokyo 141 (JP)
(72) Inventor: Nakajima, Yasuhisa, Int. Property Department, Shinagawa-ku, Tokyo 141 (JP)
(74) Representative: Robinson, Nigel Alexander Julian

(57) **Abstract**

When a video cassette having a tag adhered thereto is mounted on the information processing apparatus or brought to a position within a predetermined distance therefrom, a read-writer reads a serial number from the tag and determines whether the read serial number has already been stored in a memory. If the determination has proved that the serial number has been stored in the memory, the read-writer reads current update history data from the tag and determines whether the read current update history data coincides with the update history data that has been stored in the memory. When it has been determined that the current update history data does not coincide with that stored in the memory, the read-writer reads whole data from the tag 2 and stores the read data in the memory, from which the data is read so as to be processed. In contrast, when it has been determined that the current update history data coincides with that stored in the memory, the read-writer reads whole data of the tag from the memory and processes the read data, instead of reading the data from the tag.

## Description

The present invention relates to an information processing apparatus, information processing method and a medium that provides a program implementing the method. More particularly, the invention is concerned with an information processing apparatus, as well as an information processing method and a medium, that can, in at least preferred embodiments, shorten the time required for processing data read from a tag which incorporates a non-contact-type memory.

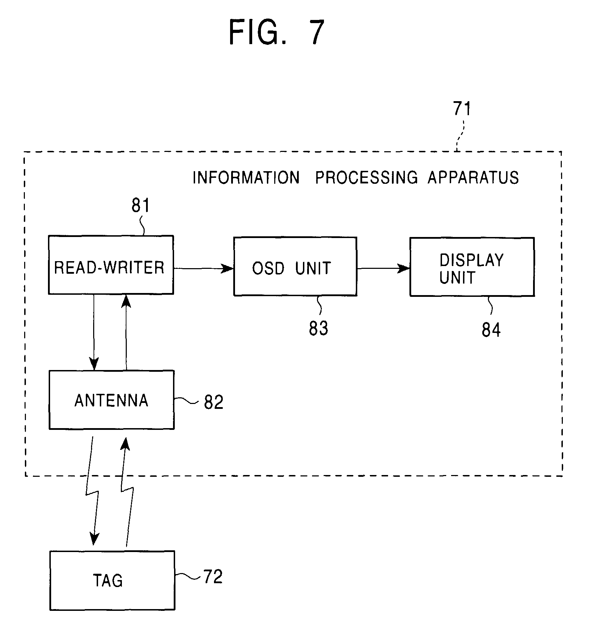

In recent years, information processing apparatuses capable of accessing tags incorporating non-contact-type memories (simply referred to as "tags", hereinafter) are finding spreading use. Fig. 7 shows, by way of example, a known information processing apparatuses capable of making access to tags. Referring to Fig. 7, when a storage medium, e.g., a video cassette, having a tag 72 adhered thereto is mounted on an information processing apparatus 71 or brought to a position which is within a predetermined distance from the same, a read-writer 81 reads data from a predetermined address (region) in a memory which is incorporated in the tag 72, via an antenna 82. The read-writer 81 transforms the thus read data into data of a predetermined format, and the thus obtained transformed data is supplied to an OSD (On Screen Display) unit 83. The OSD unit 83 converts the data received from the read-writer 81 into data suitable for display, whereby the data is displayed on the display unit 84.

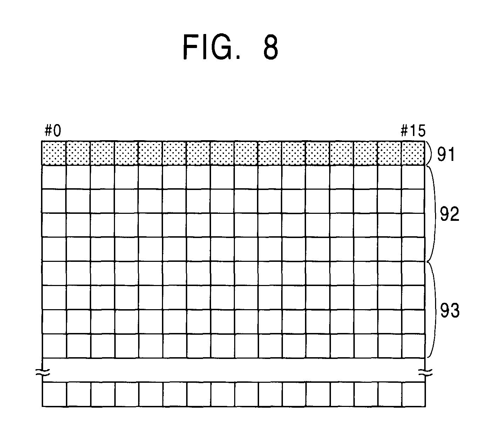

Fig. 8 shows the data architecture of the data stored in the tag 72. There are 16 bytes that determine horizontal addresses (addresses 0 to 15). As will be seen from Fig. 8, the data contained in the tag 72 is constituted by a memory management information area 91, a media information area 92, and a program information area 93. Data regions in these information areas may store character codes for designating characters to be displayed on the display unit 84. Data indicative of the contents recorded in a storage medium, e.g., the title of the program stored therein, are stored in a predetermined region of the program information area 93.

When a plurality of tags are to be dealt with at a time, the read-writer 81 reads data from all the tags successively via the antenna 82 and, after storing the whole read data in a storage area which is not shown, processes the successive data individually.

The above-described known technique, however, has a problem in that the processing of data is possible only after all the data has been read, even when data has not been changed in one or more tags, with the result that a long processing time is required to process all the data derived from the tags.

In view of the foregoing, an object of at least preferred embodiments of the present invention is to reduce the processing time required for the information processing apparatus to process data on a plurality of tags.

To this end, according to one aspect of the present invention, there is provided an information processing apparatus capable of making access to a non-contact-type storage device storing data including a serial number and data update history information, the information processing apparatus comprising: storage means for storing in advance the data including the serial number and data update history information which has been stored in the storage device; reading means for reading the serial number and the current data update history information from the storage device; comparing means for comparing the serial number and the current data update history information read by the reading means with the serial number and the data update history information which have been stored in the storage means; and processing means for executing processing of the data in accordance with the result of the comparison.

In operation of this information processing apparatus, the storage means stores in advance the data including the serial number and data update history information which has been stored in the storage device, and the reading means reads the serial number and the current data update history information from the storage device. Then, the comparing means compares the serial number and the current data update history information read by the reading means from the storage device with the serial number and the data update history information which have been stored in the storage means. The processing means then executes processing of the data in accordance with the result of the comparison.

In accordance with a second aspect of the present invention, there is provided an information processing method performed by an information processing apparatus capable of making access to a non-contact-type storage device storing data including a serial number and data update history information, the processing method comprising the steps of: storing in advance the data including the serial number and data update history information which has been stored in the storage device; reading the serial number and the current data update history information from the storage device; comparing the serial number and the current data update history information read in the reading step with the serial number and the data update history information stored in the storing step; and executing processing of the data in accordance with the result of the comparison.

The present invention in its third aspect provides a medium that provides a program to an information processing apparatus capable of making access to a non-contact-type storage device storing data including a serial number and data update history information, the program comprising the steps of: storing in advance the data including the serial number and data update history information which has been stored in the storage device; reading the serial number and the current data update history information from the storage device; comparing the serial number and the current data update history information read in the reading step with the serial number and the data update history information stored in the storing step; and executing processing of the data in accordance with the result of the comparison.

In accordance with the second and third aspects, the data including the serial number and data update history information which have been stored in the storage device are stored in the storing step, and the serial number and the current data update history information are read from the storage device in the reading step. The serial number and the current data update history information read in the reading step are compared in the comparing step with the serial number and the data update history information stored in the storing step. The executing step then executes processing of the data in accordance with the result of the comparison.

An embodiment of the invention will now be described, by way of example only, with reference to the accompanying drawings, in which:
Fig. 1 is a block diagram showing one example embodiment of the information processing apparatus of the present invention;
Fig. 2 is a block diagram showing an example of the structure of a tag 2 shown in Fig. 1;
Fig. 3 is a block diagram showing an example of the structure of the read-writer 11;
Fig. 4 is an illustration of the data architecture in a memory of the tag 2;
Fig. 5 is an illustration of the media information area 52 shown in Fig. 4;
Fig. 6 is a flowchart illustrative of the operation of an information processing apparatus 1 in accordance with one example of the present invention;
Fig. 7 is a block diagram showing the structure of a conventional information processing apparatus; and
Fig. 8 is an illustration of the data architecture in a memory of a tag 72.

A preferred embodiment of the invention will now be described. It is to be understood, however, that practical forms of elements or components described herein are shown only for illustrating purposes and are not intended to limit the scope of the present invention.

Referring to the drawings, an information processing apparatus of the present invention, capable of making access to a non-contact-type storage device storing data including a serial number and data update history information, has the following components: storage means for storing in advance the data including the serial number and data update history information which has been stored in the storage device; reading means for reading a serial number and current data update history information from the storage device; comparing means for comparing the serial number and the current data update history information read by the reading means with the serial number and the data update history information which have been stored in the storage means; and processing means for executing processing of the data in accordance with the result of the comparison.

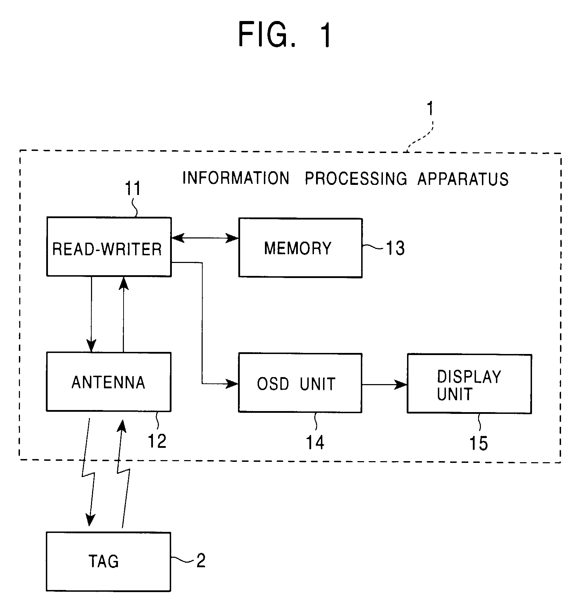

Fig. 1 is a block diagram showing the construction of an embodiment of the information processing apparatus of the present invention, generally denoted by 1. In this embodiment, a video cassette (not shown) having a tag 2 adhered thereto is employed as the storage device having a serial number and data update history information. When the video cassette is mounted on an information processing apparatus 1 or brought to a position which is within a predetermined distance from the same, a read-writer 11 reads data from a predetermined address (region) in a memory incorporated in the tag 2, via an antenna 12. The read-writer 11 transforms the thus read data into data of a predetermined format, and the thus obtained transformed data is supplied to an OSD (On Screen Display) unit 14. The OSD unit 14 converts the data received from the read-writer 11 into data suitable for display, whereby the data is displayed on the display unit 15.

When the video cassette having the tag 2 adhered thereto is mounted on the information processing apparatus 1 or brought to a position within a predetermined distance from the same, the read-writer 11 reads a later-mentioned serial number 61 from the tag 2 and determines whether the read serial number has been stored in a memory 13 which serves as the storage means. Upon determining that the serial number 61 has been stored in the memory, the read-writer 11 reads later-mentioned current update history data 62 from the tag 2.

The read-writer 11 determines whether the current update history data read from the tag 2 coincides with the update history data that has been stored in the memory 13. If the current update history data 62 is determined as being not coincident to that stored in the memory 13, the read-writer 11 reads all the remaining data from the tag 2. The read-writer 11 reads all the data from the tag 2, also when it has determined that the serial number 61 has not yet been stored in the memory 13. The read-writer 11 stores all the data read from the tag 2 and occasionally reads the stored data to process the data.

Upon determining that the read current update history data 62 coincides with that stored in the memory 13, the read-writer 11 reads whole data that has been acquired from and stored in advance in the memory 13, without taking the task of reading the data from the tag 2 itself, and processes the data read from the memory 13.

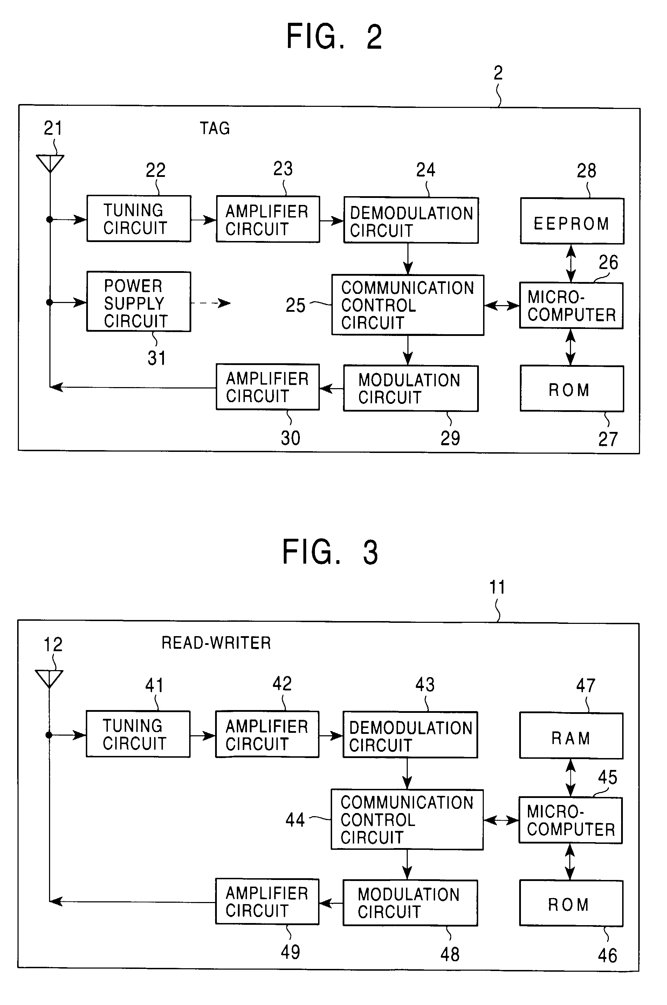

Fig. 2 is a block diagram showing the structure of the tag 2. An antenna 21 which is one of the components of the tag 2 receives later-mentioned electric waves from the read-writer 11 and supplies signals corresponding to the received electric waves both to a tuning circuit 22 and a power supply circuit 31. The tuning circuit 22 extracts, from the signals supplied by the antenna 21, the frequency of the carrier wave used for the communication between the tag 2 and the read-writer 11.

An amplifier circuit 23 amplifies the received signal to a predetermined amplitude and then outputs the amplified signal. A demodulation circuit 24 demodulates the signals that have been modulated by the carrier wave frequency, thereby forming data corresponding to the received signals. A communication control circuit 25 conducts switching between sending and receiving modes. A microcomputer 26 performs an overall control of various sections of the tag 2 in accordance with control programs stored in a ROM (Read Only Memory) 27. The microcomputer 26 also serves to supply an EEPROM (Electrically Erasable and Programmable Read Only Memory) 28 with data which has to be stored, selected from among various kinds of data received through the communication control circuit 25.

The EEPROM 28 stores data supplied by the microcomputer 26. A modulation circuit 29 modulates the data supplied from the communication control circuit 25 into signals of the carrier wave frequency and outputs the signals obtained through the modulation. An amplifier circuit 30 amplifies the signal which is received from the modulation circuit 29 and which has been modulated by the carrier wave frequency to a predetermined amplitude. The antenna 21 then transmits, by way of electric waves, the signal of the carrier wave frequency amplified by the amplifier circuit 30.

Fig. 3 is a block diagram showing the structure of the read-writer 11. An antenna 12 serves to transmit predetermined signals to the tag 2 and to conduct exchange of a predetermined carrier wave to enable communication between the tag 2 and the read-writer 11. The antenna 12 also serves to generate a magnetic field to supply electrical power to the tag 2.

A tuning circuit 41 extracts, from the signals supplied from the antenna 12, the frequency of the carrier wave used for the communication between the tag 2 and the read-writer 11. An amplifier circuit 42 amplifies the received signal to a predetermined amplitude and then outputs the amplified signal. A demodulation circuit 43 demodulates the signals that have been modulated by the carrier wave frequency, thereby forming data corresponding to the received signals. A communication control circuit 44 conducts switching between sending and receiving modes, as well as control of the communication. A microcomputer 45 performs an overall control of various sections of the read-writer 11 in accordance with control programs stored in a ROM (Read Only Memory) 46. The microcomputer 45 also serves to supply a RAM (Random Access Memory) 47 with data which has to be stored, stored, selected from among various kinds of data received through the communication control circuit 44.

The RAM 47 stores data supplied by the microcomputer 45. A modulation circuit 48 modulates the data supplied from the communication control circuit 44 into signals of the carrier wave frequency and outputs the signals obtained through the modulation. An amplifier circuit 49 amplifies the signal which is received from the modulation circuit 48 and which has been modulated by the carrier wave frequency to a predetermined amplitude that is necessary for the communication. The antenna 12 then transmits, by way of electric waves, the signal of the carrier wave frequency amplified by the amplifier circuit 49.

Exchange of data is thus possible between the tag 2 and the read-writer 11.

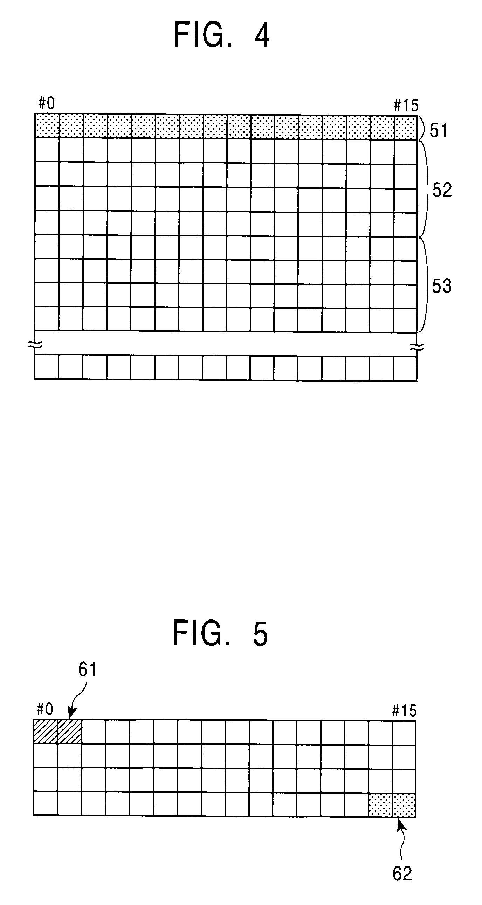

Fig. 4 shows the data architecture of the memory (EEPROM 28) in the tag 2. As will be seen from Fig. 4, the storage area in the tag 2 includes a memory management information area 51, a media information area 52, and a program information area 53. The memory management information area 51 and the media information area 52 store information which is peculiar to, for example, a video cassette. For instance, these areas store category information indicative of the use of the video cassette e.g., for general use, for business, and so on, or information indicative of the memory size, and so on. The program information area 53 stores information concerning the type of television broadcast such as NTSC, PAL or the like, or information concerning categories of broadcast programs, title of the broadcast programs, and so forth.

Fig. 5 shows the structure of the media information area 52 shown in Fig. 4. This area stores the serial number 61 (2 bytes) which is a number peculiar to this tag 2. This area also stores the current update history data 62 (2 bytes) indicative of the history of update of the data carried by this tag 2.

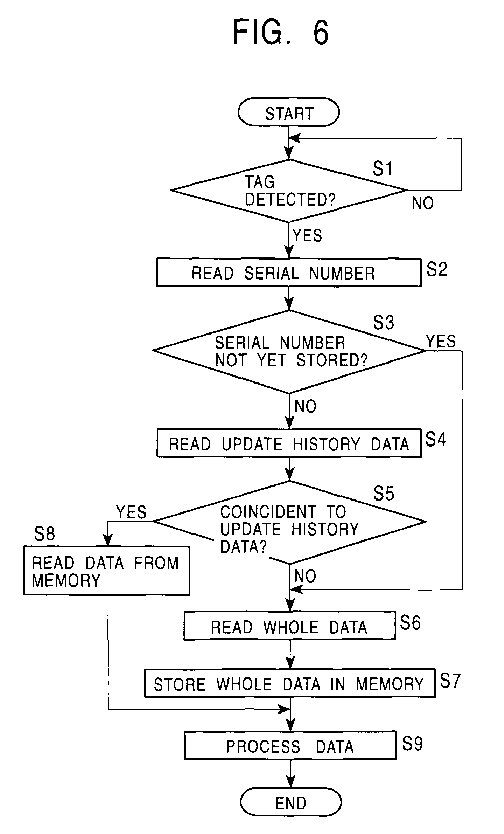

The operation of the information processing apparatus of the present invention will be described with reference to the flowchart shown in Fig. 6. When a video cassette having the tag 2 adhered thereto is mounted on the information processing apparatus 1 or brought to a position within a predetermined distance from the same, Step S1 of the flow is executed in which the read-writer 11, i.e., the microcomputer 45, determines whether the tag 2 has been detected via the antenna 12. The process repeats Step S1 when it is determined that no tag has been detected in Step S1. Step S2 is then executed when Step S1 has determined that the tag 2 has been detected.

In Step S2, the microcomputer 45 reads the serial number 61 stored in the EEPROM 28 of the tag 2 and advances the process to Step S3. In Step S3, the microcomputer 45 determines whether the serial number 61 read from the tag 2 exists in the data stored in the memory 13.

Upon determining in Step S3 that the serial number 61 has been stored in the memory 13, the process proceeds to Step S4 in which the microcomputer 45 reads the current update history data 62 stored in the EEPROM 28 of the tag 2.

In Step S5, the microcomputer 45 determines whether the current update history data 62 read from the tag 2 coincides with the update history data that has been stored in the memory 13. If the determination in Step S5 has proved that the read current update history data 62 does not coincide with that stored in the memory 13, the process advances to Step S6 in which the microcomputer 45 reads the whole data from the tag 2. Step S6, that causes the microcomputer 45 to read the whole data from the tag 2, is executed also when Step S3 has determined that the serial number 61 has not been stored in the memory 13. This reading operation is conducted because the microcomputer 45 decides that the data now stored in the tag 2 should be the latest or up-to-date data while the data stored in the memory 13 is old.

In Step S7, the microcomputer 45 operates such that the whole data read from the tag 2 is stored in the memory 13. The process then skips to Step S9 in which the microcomputer 45 reads data from the memory 13 and processes the read data, thus completing the process.

In the event that the determination in Step S5 has proved that the read current update history data 62 coincides with that stored in the memory 13, the process proceeds to Step S8 in which the microcomputer 45 reads from the memory 13 the whole data of the tag 2 that has been stored therein, instead of reading the remaining data from the tag 2. The process then proceeds to Step S9. This operation is executed because the coincidence between the read current update history data 62 and that stored in the memory 13 indicates that no change has been effected on the data of the tag 2 by, for example, another read-writer. In this case, therefore, the processing is executed on the data of the tag 2 that has been stored in the memory 13 upon reading the data from the memory 13, without requiring the task of reading the data from the tag 2.

A description will now be given as to how the actual processing time is shortened. It takes about 16 ms for the read-writer 11 to read the 64-byte data from the media information area 52 in which the serial number 61 and the update history data 62 are stored.

In the case where the serial number 61 or the current update history data 62 read by the rear-writer 11 from the tag 2 fails to coincide with that stored in the memory 13, the read-writer 11 is required to read whole data from the tag 2. Assuming that the whole data size is 1 K bytes, it takes about 256 ms to read the whole data.

In case that the serial number 61 and the update history data 62 read from the tag 2 by the read-writer 11 coincides with those stored in the memory 13, the 1 Kbytes data is read from the memory 13, rather than from the tag 2. The time required for reading the 1 K bytes data from the memory 13 is as short as about 60 µS. Consequently, the required reading time is shortened by about 256 ms.

Assuming that the read-writer 11 can detect eight tags at a time and that all the data read from these tags are stored in the memory 13, a 2048 mS (256 mS x 8) shortening of the reading time is theoretically achievable at the maximum.

The data architecture in the memory of the tag 2 employed in the described embodiment is only illustrative and not exclusive.

The providing medium that provides users with a computer program that implements the above-described process includes not only information recording media such as magnetic disks and CD-ROMs but also network transmission media such as the internet, digital satellites, and so forth.

As will be understood from the foregoing description, according to at least preferred embodiments of the present invention, a serial number and update history information that have been carried by a tag are stored in advance in a storage means such as a memory, and are compared with the serial number and current data update history information that are read from the tag, followed by processing of the data. It is therefore possible to shorten the time required for completing the processing of the data.

In so far as the embodiments of the invention described above are implemented, at least in part, using software-controlled data processing apparatus, it will be appreciated that a computer program providing such software control and a storage medium by which such a computer program is stored are envisaged as aspects of the present invention.

Although the invention has been described through its preferred form, it is to be understood that the described embodiment is only illustrative and various changes and modifications may be imparted thereto without departing from the scope of the present invention which is limited solely by the appended claims.

## Claims

1. An information processing apparatus capable of making access to a non-contact-type storage device storing data including a serial number and data update history information, said information processing apparatus comprising:
storage means for storing in advance the data including the serial number and data update history information which has been stored in said storage device;
reading means for reading the serial number and current data update history information from said storage device;
comparing means for comparing the serial number and the current data update history information read by said reading means with the serial number and the data update history information which have been stored in said storage means; and
processing means for executing processing of said data in accordance with the result of the comparison.

2. An information processing method performed by an information processing apparatus capable of making access to a non-contact-type storage device storing data including a serial number and data update history information, said processing method comprising the steps of:
storing in advance the data including the serial number and data update history information which has been stored in said storage device;
reading the serial number and current data update history information from said storage device;
comparing the serial number and the current data update history information read in said reading step with the serial number and the data update history information stored in said storing step; and
executing processing of said data in accordance with the result of the comparison.

3. A medium that provides a program to an information processing apparatus capable of making access to a non-contact-type storage device storing data including a serial number and data update history information, said program comprising the steps of:
storing in advance the data including the serial number and data update history information which has been stored in said storage device;
reading the serial number and current data update history information from said storage device;
comparing the serial number and the current data update history information read in said reading step with the serial number and the data update history information stored in said storing step; and
executing processing of said data in accordance with the result of the comparison.
